Europäisches Patentamt

European Patent Office

Office européen des brevets

(19)

(11) EP 0 915 562 A2

(12) **DEMANDE DE BREVET EUROPEEN**

(43) Date de publication:
**12.05.1999 Bulletin 1999/19**

(51) Int Cl.$^6$: **H03F 3/45**

(21) Numéro de dépôt: 98402753.2

(22) Date de dépôt: 05.11.1998

(84) Etats contractants désignés:
**AT BE CH CY DE DK ES FI FR GB GR IE IT LI LU MC NL PT SE**
Etats d'extension désignés:
**AL LT LV MK RO SI**

(30) Priorité: **07.11.1997 FR 9714018**

(71) Demandeur: **STMicroelectronics SA**
**94250 Gentilly Cedex (FR)**

(72) Inventeur: **Yero, Emilio**
**94230 Cachan (FR)**

(74) Mandataire: **Ballot, Paul**
**Cabinet Ballot-Schmit,**
**16, Avenue du Pont Royal**
**94230 Cachan (FR)**

(54) **Amplificateur différentiel à transistor MOS**

(57)  Dans un amplificateur différentiel à sorties asymétriques, les grilles des deux transistors de charge (M1, M2) sont à un même potentiel déterminé ($P_{OFF}$) et la tension ($V_A$) au noeud de connexion (A) entre le transistor de charge (M1) et le transistor amplificateur (M3) d'une branche est stabilisée au moyen d'une structure de compensation (M6, M7, M8). Cet amplificateur fonctionne à bas Vcc (<2volts) tout en ayant un bon gain.

# FIG_3

## Description

La présente invention concerne un amplificateur différentiel à transistor MOS.

Les amplificateurs différentiels sont utilisés dans nombre de circuits intégrés. On s'intéresse plus particulièrement aux amplificateurs qui ne comprennent qu'un seul étage, qui doit donc avoir un gain élevé comme ceux utilisés notamment dans les circuits de lecture des mémoires non-volatiles. Pour ce genre d'application, on utilise en général des amplificateurs différentiels à sorties asymétriques, qui utilisent pour cela comme charge active, une structure miroir de courant.

Si ces amplificateurs différentiels à sorties asymétriques sont largement utilisés, on a pu cependant constater qu'ils ne fonctionnaient pas très bien à trop basse tension d'alimentation logique Vcc. On sait en effet que les efforts technologiques portent en particulier sur la baisse du niveau de tension d'alimentation logique des circuits intégrés. On cherche en particulier à faire travailler ces circuits sous 2 volts, voire sous 1 volt. Or avec un montage à miroir de courant, on a un transistor monté en diode, ce qui entraîne une chute de tension systématique d'un seuil de transistor, de l'ordre de 0,8 volt pour un transistor de type P. Avec une tension d'alimentation logique Vcc de deux volts, cela représente une chute de tension de près de la moitié. On comprend donc que cette chute de tension inhérente à la structure de cet amplificateur constitue un réel facteur de limitation à bas Vcc.

Un objet de l'invention est de résoudre ce problème technique de limitation à bas Vcc, tout en préservant un gain élevé.

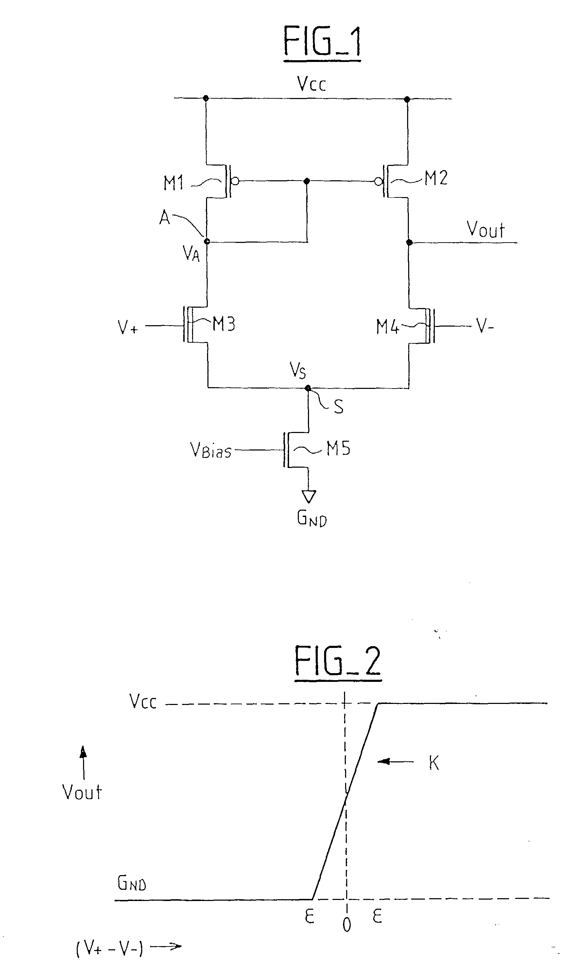

Pour mieux comprendre la nature du problème technique à résoudre, on a représenté sur la figure 1, un schéma d'un amplificateur différentiel à transistors MOS de l'état de la technique, utilisé en particulier dans les circuits de lecture de mémoires non-volatiles pour comparer la tension sur une ligne de bit à une tension de référence.

L'amplificateur différentiel comprend une première branche et une deuxième branche connectées en parallèle d'un côté à une première tension d'alimentation et de l'autre, à un transistor de polarisation M5 connecté à une deuxième tension d'alimentation, et recevant sur sa grille un potentiel de polarisation. Chaque branche comprend un transistor de charge M1 ou M2 et un transistor amplificateur M3 ou M4 en série. Les transistors de charge sont montés en miroir de courant, le transistor M1 étant monté en diode (grille et drain reliés). Le point de connexion entre le transistor de charge M1 et le transistor amplificateur M3 est noté A, et est au potentiel VA. Le point de connexion entre le transistor de charge M2 et le transistor amplificateur M4 est la sortie OUT de l'amplificateur. Les deux entrées positive E1 et négative E2 de cet amplificateur différentiel à sorties asymétriques sont constituées respectivement par la grille du transistor M3 et la grille du transistor M4. On leur applique les deux tensions à comparer, conventionnellement notées $V_+$ pour E1 et $V_-$ pour E2.

Dans l'exemple, on s'est placé en technologie $C_{MOS}$. Le transistor Mos M1 est ainsi de type P et connecté en diode polarisée en direct, avec sa grille reliée à son drain. Sa source est reliée à la tension d'alimentation VCC. Son drain est relié au drain du transistor MOS M3, qui est de type N. Le transistor Mos M2 de charge est aussi de type P et sa grille est reliée à la grille du transistor M1, (monté en diode). Sa source est reliée à la tension VCC. Son drain est relié au drain du transistor M4, de type N.

Les sources des transistors M3 et M4 sont reliées ensemble, en un point noté S, au drain du transistor M5 de polarisation en courant, de type N.

Dans l'exemple, les transistors amplificateurs M3 et M4 sont natifs, c'est à dire avec une tension de seuil $V_{tw}$ très faible, ce qui est représenté par une double barre sur le dessin.

Dans un exemple d'utilisation de cet amplificateur dans un circuit de lecture d'une mémoire, on retrouve sur l'une des entrées du comparateur, dans l'exemple sur l'entrée E1, la tension BL d'une ligne de bit de la mémoire (celle qui est lue) et sur l'autre entrée, dans l'exemple E2, la tension de référence de lecture VREF. Dans une telle application, les entrées BL et VREF ont un niveau de tension maximum de 1 volt.

Le fonctionnement idéal d'un tel comparateur suit la courbe caractéristique définie comme suit :

SI $V_+$-$V_-$>0 ALORS VOUT=VCC ET
SI $V_+$-$V_-$<0 ALORS VOUT=GND.

Cette caractéristique idéale a un gain infini quand $V_+$=$V_-$.

Dans les conditions de fonctionnement réel, on a un gain important au voisinage de $V_+$=$V_-$. Si on note K ce gain, la courbe correspondante est celle représentée sur la figure 2, et définie comme suit :

SI $V_+$ - $V_-$ > ε ALORS VOUT = VCC ET
SI $V_+$ - $V_-$ < -ε ALORS VOUT = GND
SI -ε < $V_+$ - $V_-$ < +ε
ALORS VOUT = K ($V_+$ - $V_-$) + VCC/2.

Pour que cette fonction soit continue, on doit avoir comme relations :

$$(1) \qquad K.\varepsilon = VCC/2 \text{ soit}$$

$$(2) \qquad 2.\varepsilon = VCC/K .$$

Ces relations (1) ou (2) montrent clairement que la zone critique entre -ε et +ε, dans laquelle la tension de sortie VOUT n'est ni VCC ni GND, est d'autant plus étroite que le gain est élevé : plus le gain est élevé, plus on se rapproche de la caractéristique idéale.

Il est donc très important d'avoir un gain optimum, le plus grand possible. C'est pour cette raison que tous les transistors M1 à M4 de l'amplificateur doivent fonctionner en mode saturé, surtout dans la zone critique [-ε;+ε] .

Dans la suite, on va montrer que cette condition ne peut être atteinte dans le circuit de l'état de la technique que pour une tension d'alimentation supérieure à environ 2 volts, en se basant sur des valeurs typiques dans une technologie CMOS donnée.

La zone qui nous intéresse plus particulièrement est la zone critique [-ε;+ε], correspondant au basculement de la sortie VOUT de l'amplificateur. C'est à ce moment qu'il faut le plus grand gain possible.

Dans les calculs qui vont suivre, on se place à $V_+=V_-$, avec des transistors M1 à M5 en mode saturé. Les transistors M1 et M2 sont identiques, les transistors M3 et M4 sont identiques.

Dans un premier temps, on va calculer la valeur du gain de mode différentiel K en petits signaux d'un tel amplificateur, en se plaçant à $V_+=V_-$ et en considérant que autour de ce point $\Delta V_+=-\Delta V_-$.

On suppose VS constant. On prend en outre les conventions de notation suivantes :

$g_{Mi}$ est le gain d'un transistor Mi en mode saturé ($g_{Mi}=\mu_0 C_{ox}W/2L$);
$V_{tn}$ est la tension de seuil d'un transistor MOS de type N (M5);
$V_{tw}$ est la tension de seuil d'un transistor MOS de type N natif, (M3 ou M4) ;
$V_{tp}$ est la tension de seuil d'un transistor MOS de type P (M1, M2);
VDF est la tension différentielle d'entrée égale à $(V_+-V_-)/2$;
K est le gain de mode différentiel, égal à $\Delta VOUT/\Delta VDF$;
$G_{Mi}$ est la transconductance en petits signaux pour le transistor Mi, égale à $\delta IDS/\delta VGS$; et
$r_{0Mi}$ est la résistance de saturation de drain du transistor Mi, due à la modulation de la largeur du canal.

La variation de courant dans la branche (M1, M3) est :

$$\Delta I_{M3}=G_{M3}\cdot\Delta V_+ .$$

Comme ce courant passe dans la branche (M2, M4) par le miroir de courant formé par les transistors M1 et M2, la variation de courant dans cette branche est:

$$\Delta I_{M2}=\Delta I_{M3}=G_{M3}\cdot\Delta V_+ .$$

Comme $G_{M3}=G_{M4}$ (transistors identiques) et $\Delta V_+=-\Delta V_-$ (mode différentiel), on a donc

$$\Delta I_{M2}=-\Delta I_{M4}.$$

Le courant de sortie est :

$$\Delta I_{M2}-\Delta I_{M4}=2\Delta I_{M2}=2\Delta I_{M3}=2G_{M3}\Delta V_+=2G_{M4}\Delta V_+ .$$

Ce courant passe dans la résistance de sortie équivalente (en petits signaux) correspondant à la résistance de saturation $r_{0M2}$ du transistor M2 en parallèle sur la résistance de saturation $r_{0M4}$ du transistor M4. La variation de la tension de sortie est donc :

$$\Delta VOUT=2G_{M4}\Delta V_+(r_{0M2}//r_{0M4}).$$

Avec $\Delta VDF=(\Delta V_+-\Delta V_-)/2=\Delta V_+$, on en déduit la valeur du gain de mode différentiel :

$$K=\Delta VOUT/\Delta VDF=2G_{M4}\Delta V_{+}(r_{0M2}//r_{0M4}).$$

Nous allons maintenant chercher la condition sur la tension d'alimentation VCC pour que les transistors soient bien en mode de saturation.

Le courant I3 passant dans le transistor M3 et le courant I4 passant dans le transistor M4 sont égaux et donnés par la relation (a) suivante en mode saturé :

$$(a) \qquad I3=I4=g_{M3}(V_{+} - V_{-} - V_{tw})^{2}.$$

Si le transistor M3 est saturé, on a par ailleurs la relation (b) suivante :

$$(b) \qquad V_{A}>V+ - V_{tw}.$$

Le courant I1 dans le transistor M1 et le courant I2 dans le transistor M2 sont égaux et donnés par la relation (c) suivante :

$$(c) \qquad I1=I2=g_{M1}(VCC - VA - V_{tp})^{2}.$$

Comme les transistors M1 et M2 sont en série, on a I1=I3, et donc :

$$(d) \qquad g_{M1}(VCC - VA - V_{tp})^{2}=g_{M3}(V_{+} - V_{-} - V_{tw})^{2}.$$

si on note $\gamma=(g_{M3}/g_{M1})$, on a donc :

$$(e) \qquad VA=VCC - V_{tp} - \gamma(V_{+} - VS - V_{tw}).$$

De la relation (b) de saturation du transistor M3, il vient :

$$VCC - V_{tp} - \gamma(V_{+} - VS - V_{tw}) > V_{+} - V_{tw}.$$

Il faut donc, pour réaliser la condition de saturation que la tension d'alimentation VCC soit telle que :

$$VCC> (\gamma+1) (V_{+} - V_{tw}) + V_{tp} - \gamma VS.$$

Avec les valeurs typiques suivantes : $V_{tp}$=0.8 volt ; $\gamma$=1 ; $V_{tw}$=0.4 volt ; VS=0.2 volt et pour une application de type circuit de lecture d'une mémoire, dans laquelle on aura $V_{+}$=1 volt , il faut donc que VCC > 1.8 volt pour garantir la condition de saturation des transistors.

En pratique pour les circuits alimentés en VCC de 2 volts en nominal, le fonctionnement du circuit doit être garanti jusqu'à au moins 1.6 volt. On voit que la condition de saturation n'est plus remplie à cette valeur. On ne peut donc pas envisager utiliser ce circuit à moins de VCC=3 volts.

Pour garantir la condition de saturation à plus bas VCC, on pourrait diminuer la valeur du rapport $\gamma$ des gains des transistors M1 et M3. Mais pour VCC=1.6 volt, il faudrait $\gamma$=0,25. En pratique, cela veut dire que le transistor M1 de type P devrait avoir 8 fois le gain du transistor M3 de type N, natif. Comme en outre le gain par unité de largeur d'un transistor de type P est égal à la moitié de celui d'un transistor natif, cela veut dire qu'il faudrait en fait un rapport de taille de 16 à 1 entre le transistor M1 de type P et le transistor M1 natif. Un si large transistor M3 impose de fortes contraintes de dessin et augmente les charges parasites impliquant une réduction des vitesses de commutation. Cette solution n'est donc pas acceptable.

Une autre voie pour arriver à garantir cette inégalité est de changer de technologie, de manière à avoir des tensions de seuil de transistors ($V_{tw}$ et $V_{tp}$) encore plus bas. Cette solution n'est pas intéressante, car si on réduit les tensions de seuil, on augmente nécessairement les courants de fuites sous seuil. Ceci est particulièrement gênant

EP 0 915 562 A2

pour les applications dites portables, utilisant des circuits intégrés alimentés par batterie.

Dans l'invention, on a cherché une autre voie pour garantir la condition de saturation, même à basse tension d'alimentation logique VCC tout en préservant le gain de cet amplificateur.

Une solution à ce problème technique a été trouvée dans l'invention dans un amplificateur à sorties symétriques dans laquelle les grilles des transistors de charge sont polarisées à un même potentiel déterminé. On a alors deux sources de courant proprement dites et les courants varient dans le même sens dans les deux branches. C'est à dire que si on a une variation $\Delta i$ dans une branche, on aura une variation $\Delta i$ dans l'autre branche, soit $2.\Delta i$ au total. Le gain est donc divisé par deux.

Pour cette raison, on un circuit de stabilisation de la tension VA au point milieu A de la branche (M1, M3), pour absorber la variation du courant.

Dans une première variante de réalisation de l'invention, ce circuit de stabilisation comprend un transistor en parallèle sur le transistor de polarisation pour absorber la variation de courant.

Dans une deuxième variante de réalisation, ce circuit de stabilisation comprend un premier transistor connecté entre la tension d'alimentation VCC et le point milieu A et un deuxième transistor connecté entre la tension d'alimentation VCC et la sortie Out, pour absorber la variation de courant.

Telle que revendiquée, l'invention concerne donc un amplificateur différentiel à transistors MOS, comprenant une première branche et une deuxième branche connectées en parallèle d'un côté à une première tension d'alimentation et de l'autre, à un transistor de polarisation connecté à une deuxième tension d'alimentation, et recevant sur sa grille un potentiel de polarisation, chaque branche comprenant un transistor de charge et un transistor amplificateur en série, le point de connexion entre le transistor de charge et le transistor amplificateur d'une branche étant la sortie dudit amplificateur. Selon l'invention, les grilles des transistors de charges sont commandées par un même potentiel déterminé et l'amplificateur comprend un circuit de stabilisation du potentiel du point de connexion entre le transistor de charge et le transistor amplificateur de l'autre branche.

D'autres caractéristiques et avantages de l'invention sont présentés dans la description suivante, faite à titre indicatif et non limitatif de l'invention, en référence aux dessins annexés dans lesquels :

- la figure 1 déjà décrite représente un circuit amplificateur différentiel à miroir de courant selon l'état de la technique ,
- la figure 2 déjà décrite montre la courbe caractéristique de réponse d'un tel amplificateur et
- les figures 3 et 4 représentent un circuit amplificateur différentiel selon deux modes de réalisation de l'invention.

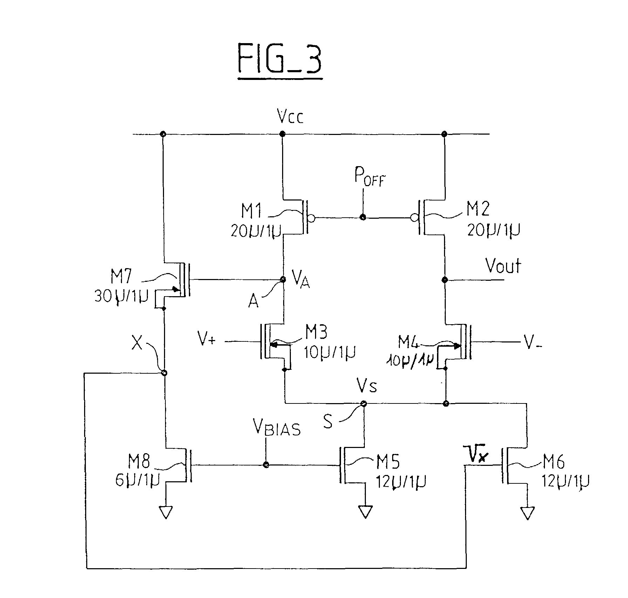

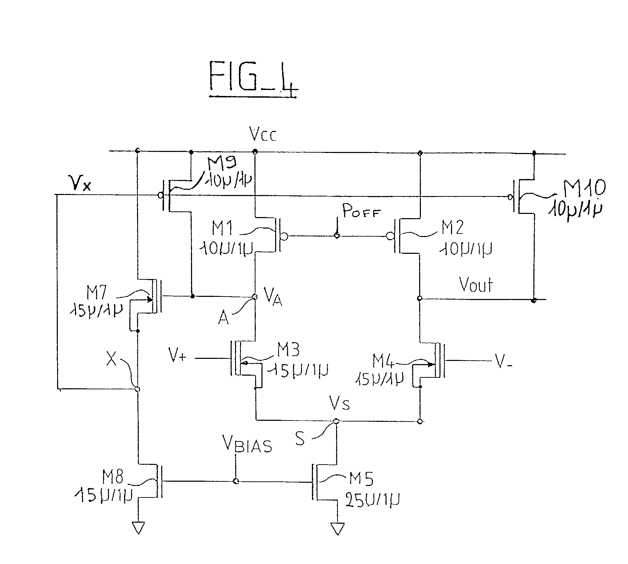

Les mêmes éléments des figures 1, 3 et 4 portent les mêmes références. Les figures 1 et 2 ayant déjà été décrites, on va s'attacher à décrire les figures 3 et 4.

Dans l'amplificateur selon un premier mode de réalisation de l'invention représenté sur la figure 3, les transistors de charge M1 et M2 ne sont plus montés en miroir de courant. Ils ont seulement leurs grilles reliées ensemble et polarisées à une même tension de polarisation notée POFF, ce qui permet d'assurer que les deux branches de l'amplificateur seront symétriques en mode commun. Cette tension de polarisation POFF est en principe générée en interne par le circuit intégré qui comprend cet amplificateur.

Un circuit de stabilisation du potentiel VA au point de connexion A de l'amplificateur comprend, selon ce premier mode de réalisation de l'invention, un transistor MOS M6 de compensation placé en parallèle sur le transistor de polarisation M5. Il est de même type, dans l'exemple de type N.

Ce transistor de compensation permet d'absorber les variations en courant, ce qui permet de stabiliser le potentiel VA. Ce transistor est faiblement conducteur. En pratique, il est choisi identique au transistor de polarisation M5.

Ce transistor M6 de compensation est contrôlé par un circuit de polarisation dynamique de sa grille.

Ce circuit de polarisation dynamique comprend un transistor M7 et un transistor M8 connectés en série entre la tension d'alimentation Vcc et la masse. Le transistor M7 est de même type que le transistor M3. Dans l'exemple il est de type N et natif. Il a sa grille commandée par le noeud A. Le transistor M8 est de même type que le transistor M5. Dans l'exemple, il est de type N. Il est faiblement passant et commandé sur sa grille par la tension de polarisation VBIAS. le point milieu X de la connexion série (M7, M8) du circuit de polarisation dynamique fournit la tension de contrôle de la grille du transistor M6.

Un tel circuit de stabilisation rend l'amplificateur différentiel très performant à basse tension d'alimentation. Il permet de maintenir la condition de saturation sur les transistors tout en préservant le gain de l'amplificateur à miroir de courant de l'état de la technique.

Tout d'abord, le fonctionnement d'un tel amplificateur avec un circuit de stabilisation selon l'invention est le suivant. Les transistors de charge M1 et M2 sont identiques. Les transistors amplificateurs M3 et M4 sont identiques. Si $V_+ = V_-$, on a le même courant dans les deux branches. Ce courant est noté $I+\Delta I$, $\Delta I$ étant fonction de la variation de potentiel au noeud A.

En S, le courant à absorber est donc $2I+2\Delta I$. La composante fixe 21 est absorbée par le transistor de polarisation M5. Le transistor M6 sert à absorber la composante variable $2\Delta I$.

L'ensemble M6, M7, M8 assure une fonction de compensation (par contre réaction) de la variation de potentiel au noeud A. Supposons en effet que le potentiel VA tende à augmenter, le transistor M7 devient alors plus passant, le transistor M8 aussi (M8 faiblement passant). Comme la tension de grille du transistor M8 est fixée (VBIAS), c'est le potentiel au point milieu de connexion X entre les deux transistors qui augmente, faisant conduire plus le transistor M6. Ce transistor tire donc plus de courant, ce qui tend à faire augmenter la composante $\Delta I$ dans la branche (M1, M3). Le potentiel VA au noeud A tend donc à diminuer. Un raisonnement similaire pour une variation inverse de VA conduit au même résultat. On a ainsi une compensation des variations. Le potentiel VA est donc stabilisé, ce qui permet de limiter les pertes sur le gain.

On va montrer que dans la zone critique qui nous intéresse, le gain est identique à celui de la structure à miroir de courant de l'état de la technique et que la condition de saturation de la nouvelle structure permet en outre de reculer la limite basse de VCC.

Commençons par le calcul du gain en mode différentiel en reprenant les mêmes conditions de calcul que précédemment.

Le courant dans M1 est fixe puisque sa grille est à POFF, sa source est à VCC et Son drain est à VA, stabilisé. Donc le courant dans le transistor M3 est fixé.

Cela veut dire que si il y a une variation $\Delta V_+$ sur l'entrée E1, cette variation va se reporter sur VS.

On a donc $\Delta V_+ = \Delta VS$.

Comme on considère le gain en mode différentiel, on a aussi $\Delta V_+ = -\Delta V_-$

La variation de courant dans la branche (M2, M4) est donc :

$$\Delta I_{M4} = G_{M4} (\Delta V_- - \Delta VS) = -2G_{M4}(\Delta V_+).$$

Le courant sur le noeud de sortie est

$\Delta I_{M2} - \Delta I_{M4} = -\Delta I_{M4}$, car le courant dans le transistor M2 est stable ($\Delta I_{M2} = 0$). On a donc

$$\Delta VOUT = -\Delta I_{M4}(r_{0M2}//r_{0M4})$$

$$\Delta VOUT = 2G_{M4} (\Delta V_+) (r_{0M2}//r_{0M4})$$

$$\Delta VOUT = 2 (\Delta VDF)G_{M4} (r_{0M2}//r_{0M4})$$

soit donc

$$K = \Delta VOUT/\Delta VDF = 2G_{M4}(r_{0M2}//r_{0M4})$$

On a donc la même valeur de gain que dans le circuit de l'état de la technique avec miroir de courant (sorties asymétriques).

Si on s'intéresse maintenant à la condition de saturation des transistors.

La condition de saturation sur le transistor M1 donne la relation :

$$(3) \qquad VCC\text{-}POFF\text{-}V_{tp} < VCC\text{-}VA, \text{ soit } VA < POFF + V_{tp}.$$

La condition de saturation sur le transistor M3 donne la relation :

$$(4) \qquad VA > V_+ \text{-}V_{tw} \text{ ou } V_+ < VA + V_{tw}.$$

Or le potentiel VA est fixé par les transistors M6 et M7. Ainsi VA est égal à la chute de tension grille source de ces transistors, soit :

$$VA = V_{tn} + V_{tw} = 1{,}2 \text{ volt.}$$

Avec des valeurs typiques de VBIAS (200mv) et en prenant POFF+$V_{tp}$=VCC-VBIAS, les conditions de saturation (3) et (4) sont donc toujours remplies à VCC=1.4 volt.

On comprend donc tout l'intérêt d'un amplificateur selon l'invention qui permet de garder le même gain qu'un amplificateur à sorties asymétriques, tout en permettant de travailler à bas VCC, et ce , sans céder sur les fuites de courant ou sur la vitesse du circuit.

En pratique, on s'arrange pour que le transistor M6 soit toujours légèrement passant. La valeur du courant dans les deux branches en mode commun étant imposée par le potentiel POFF, on choisit VBIAS et POFF de façon à ce que les transistors de charge passent chacun un courant par exemple de l'ordre de 7.5 micro-ampères, de façon à ce que le transistor M5 passe seulement environ 10 micro-ampères. De cette façon, comme il y a 15 micro-ampères (2 fois 7.5) à écouler au noeud S, le transistor M6 passe les 5 micro-ampères restant. De cette façon, le transistor M6 est toujours légèrement passant, et c'est la tension Vx du circuit de polarisation dynamique qui de-là agit sur ce transistor selon qu'il y a plus ou moins de courant en excès.

La figure 4 représente un autre mode de réalisation de l'invention. Les éléments communs à la figure 3 poretent les mêmes références.

Dans ce deuxième mode de réalisation, le circuit de stabilisation comprend deux transistors de compensation M9 et M10 pour absorber les variations de courant. Le premier transistor de compensation M9 est connecté entre la tension d'alimentation VCC et le point de connexion A et le deuxième transistor de compensation est connecté entre la tension d'alimentation VCC et la sortie Out de l'amplificateur.

En pratique et comme représenté, ces transistors M9 et M10 sont des transistors MOS de type P. On s'arrange pour qu'ils soient toujours légèrement passants, comme déjà expliqué dans le cadre du premier mode de réalisation pour le transistor M6.

Ces transistors de compensation sont contrôlés par le même potentiel de grille Vx fournit par un circuit de polarisation dynamique. Dans l'exemple, ce circuit de polarisation dynamique est identique à celui déjà vu en relation à la figure 3.

Le circuit de stabilisation selon ce deuxième mode de réalisation de l'invention, fonctionne selon le même principe déjà expliqué.

Il permet un contrôle plus direct que dans le premier mode de réalisation, puisque le transistor de compensation M9 est directement connecté au potentiel à stabiliser, mais nécessite un transistor supplémentaire M10, pour maintenir la symétrie dans l'amplificateur.

Dans un perfectionnement représenté sur les figures 3 et 4, dans le cas où la technologie permet l'isolement des caissons des transistors de type N (technologie dite tripple wells par exemple), on peut supprimer l'effet substrat en reliant le substrat à la source pour chacun des transistors M3, M4 et M7. On minimise ainsi la tension de seuil des transistors, ce qui permet d'améliorer le fonctionnement à bas VCC de l'amplificateur.

**Revendications**

1.  Amplificateur différentiel à transistors MOS, comprenant une première branche et une deuxième branche connectées en parallèle d'un côté à une première tension d'alimentation (VCC) et de l'autre, à un transistor de polarisation (M5) connecté à une deuxième tension d'alimentation (GND), et recevant sur sa grille un potentiel de polarisation (VBIAS), chaque branche comprenant un transistor de charge (M1, M2) et un transistor amplificateur (M3, M4) en série, le point de connexion entre le transistor de charge (M2) et le transistor amplificateur (M4) d'une branche étant la sortie (OUT) dudit amplificateur, caractérisé en ce que les grilles des transistors de charge (M1, M2) sont commandées par un même potentiel déterminé (POFF) et en ce qu'il comprend un circuit de stabilisation du potentiel (VA) du point de connexion (A) entre le transistor de charge (M1) et le transistor amplificateur (M3) de l'autre branche.

2.  Amplificateur différentiel selon la revendication 1, caractérisé en ce que le circuit de stabilisation comprend un transistor (M6) de compensation connecté en parallèle sur le transistor de polarisation (M5) et commandé sur sa grille par un circuit de polarisation dynamique.

3.  Amplificateur différentiel selon la revendication 1, caractérisé en ce que le circuit de stabilisation comprend un premier transistor de compensation (M9) connecté entre la première tension d'alimentation (VCC) et ledit point de connexion (A) et deuxième transistor de compensation (M10) connecté entre la première tension d'alimentation (VCC) et la sortie (Out), commandés sur leurs grilles par un circuit de polarisation dynamique.

4.  Amplificateur différentiel selon la revendication 2 ou 3, caractérisé en ce que le circuit de polarisation comprend un premier transistor (M7) et un deuxième transistor (M8) connectés en série entre la première tension d'alimentation (VCC) et la masse, la grille du premier transistor (M7) étant connectée au dit point de connexion (A), le point de connexion (x) entre le premier transistor (M7) et le deuxième transistor (M8) fournissant la tension de contrôle (Vx) de grille du ou des transistors de compensation (M6, M9, M10).

**5.** Amplificateur différentiel selon la revendication 4, caractérisé en ce que le deuxième transistor (M8) et le transistor de polarisation (M5) sont polarisés au même potentiel de grille (Vbias).

**6.** Amplificateur différentiel selon la revendication 4 ou 5, caractérisé en ce que le deuxième transistor (M8) du circuit de polarisation dynamique est faiblement passant.

**7.** Amplificateur selon l'une des revendications 2 à 6, caractérisé en ce que le ou les transistors de compensation (M6, M9, M10) sont toujours passants.

**8.** Amplificateur selon l'une quelconque des revendications 3 à 7, caractérisé en ce que les transistors de charge (M3, M4) et le premier transistor (M7) du circuit de polarisation dynamique ont chacun leur substrat relié à leur source.

**9.** Circuit de lecture d'une mémoire, caractérisé en ce qu'il comprend un amplificateur différentiel selon l'une quelconque des revendications précédentes.

**10.** Circuit intégré à mémoire, caractérisé en ce qu'il comprend un circuit de lecture selon la revendication 9.

**11.** Circuit intégré selon la revendication 10, caractérisé en ce qu'il est réalisé en technologie CMOS.

# FIG_1

# FIG_2

# FIG_3

FIG_4